# EUROPÄISCHE PATENTSCHRIFT

(11) **EP 3 779 526 B1**
(45) Veröffentlichungstag und Bekanntmachung des Hinweises auf die Patenterteilung: **16.09.2026**
(21) Anmeldenummer: 20187203.3
(22) Anmeldetag: 22.07.2020
(51) Int. Cl.: G02B 5/08, C23C 14/00, C23C 14/14

(54) **VERFAHREN ZUR HERSTELLUNG EINER ALUMINIUMSCHICHT UND OPTISCHES ELEMENT**
METHOD OF MANUFACTURING AN ALUMINUM LAYER AND OPTICAL ELEMENT
PROCÉDÉ DE FABRICATION D'UNE COUCHE D'ALUMINIUM ET ÉLÉMENT OPTIQUE

(30) Priorität: 16.08.2019 DE 102019122078
(43) Veröffentlichungstag der Anmeldung: 17.02.2021
(73) Patentinhaber: Fraunhofer-Gesellschaft zur Förderung der angewandten Forschung e.V., 80686 München (DE); Friedrich-Schiller-Universität Jena, 07743 Jena (DE)
(72) Erfinder: Stempfhuber, Sven, 07743 Jena (DE); Gäbler, Dieter, 07745 Jena (DE); Schenk, Paul, 07743 Jena (DE); Munzert, Peter, 07745 Jena (DE); Schwinde, Stefan, 07745 Jena (DE)
(74) Vertreter: Epping - Hermann - Fischer

(56) Entgegenhaltungen:
- WO-A1-2019/132714
- DE-T2- 69 026 783
- US-A1- 2011 134 514
- US-A1- 2015 191 815
- US-A1- 2015 293 275
- US-A1- 2017 315 276

## Beschreibung

Die Erfindung betrifft ein Verfahren zur Herstellung einer Aluminiumschicht, die insbesondere als Spiegelschicht in einem optischen Element vorgesehen sein kann, und ein optisches Element mit der Aluminiumschicht.

Aluminium als Material für Reflektoren wird überwiegend im UV-Bereich eingesetzt, da Aluminium für diesen Wellenlängenbereich eine hohe Reflexion besitzt. Um diese hohe Reflexion zu erreichen, sind möglichst reine Aluminiumschichten ohne Verunreinigungen notwendig, was beispielsweise durch erhöhte Abscheideraten erreicht werden kann. Allerdings kann eine höhere Abscheiderate des Aluminiums zu einer erhöhten Oberflächenrauheit der Aluminiumschicht führen.

Um Reflexionsverluste durch Oxidation der Aluminiumschicht zu vermeiden, wird das Aluminium mit fluorhaltigen Schutzschichten abgedeckt. Hierzu wird das Aluminium meist bei Raumtemperatur auf das Substrat aufgebracht und direkt anschließend mit einer dünnen Schutzschicht abgedeckt. Anschließend wird das Substrat auf eine höhere Temperatur erhitzt, da bei höheren Abscheidetemperaturen die fluorhaltigen Schichten dichter aufwachsen. Allerdings findet bei Temperaturen T > 100 °C eine Umstrukturierung des Aluminiums statt, welche ebenfalls zu einer Erhöhung der Oberflächenrauheit führen kann. Außerdem können durch die Erhitzung Löcher in der Aluminiumschicht entstehen.

In der Druckschrift DE 690 26 783 T2 ist ein Verfahren zum Herstellen einer selektiv niedergeschlagenen Schicht mit Anwendung von Alkylaluminiumhydrid angegeben.

Die Druckschrift US 2015/0191815 A1 betrifft Verfahren zur Herstellung von Panels mit geringer Emissivität.

In der Druckschrift US 2017/0315276 A1 wird ein temperatur- und korrosionsstabiler Oberflächenreflektor angegeben.

Die Druckschrift US 2015/0293275 A1 beschreibt ein Verfahren zur Beschichtung von Metall-basierten optischen Spiegelsubstraten.

In der Druckschrift WO 2019/132714 A1 ist ein Verfahren zur Herstellung einkristalliner Metallfilme angegeben, bei dem eine Metallkeimschicht durch physikalische Gasphasenabscheidung auf einem Substrat abgeschieden wird.

Eine zu lösende Aufgabe besteht somit darin, ein Verfahren zur Herstellung einer Aluminiumschicht anzugeben, mit dem eine Aluminiumschicht mit geringer Rauheit herstellbar ist, die auch bei erhöhten Temperaturen nicht wesentlich zunimmt. Weiterhin soll ein optisches Element mit einer solchen Aluminiumschicht angeben werden.

Bei dem Verfahren wird eine dünne metallische Keimschicht auf ein Substrat aufgebracht, wobei die Keimschicht eine Dicke von nicht mehr als 5 nm aufweist. Nach dem Herstellen der Keimschicht wird bei dem Verfahren die Aluminiumschicht auf die Keimschicht aufgebracht. Die Aluminiumschicht weist eine Dicke von mindestens 30 nm auf. Es hat sich herausgestellt, dass auf diese Weise eine Aluminiumschicht mit sehr geringer Rauheit hergestellt werden kann. Die Keimschicht wird von der Aluminiumschicht insbesondere vollständig überwachsen, so dass eine Aluminiumschicht mit planer Oberfläche entsteht.

Die Erfindung macht insbesondere von der Erkenntnis Gebrauch, dass durch das vorherige Aufbringen der Keimschicht Einfluss auf das Schichtwachstum der Aluminiumschicht genommen werden kann. Insbesondere wird mit dem hier beschriebenen Verfahren eine veränderte kristalline Struktur des Aluminiums erzielt. Dies führt dazu, dass eine Aluminiumschicht mit einer geringeren Oberflächenrauheit hergestellt werden kann. Die Aluminiumschicht kann bei der Abscheidung auf der Keimschicht insbesondere polykristallin sein, wobei ein Anteil an Kristalliten in (111)-Orientierung größer ist als bei einer direkten Abscheidung der Aluminiumschicht auf dem Substrat. Es wird vermutet, dass die geänderte Kristallstruktur des polykristallinen Aluminiums bei der Abscheidung auf der metallischen Keimschicht die verringerte Oberflächenrauheit bewirkt.

Es hat sich herausgestellt, dass insbesondere die Dicke der Keimschicht kritisch für die Oberflächenrauheit der Aluminiumschicht ist. Vorzugsweise beträgt die Dicke der Keimschicht 2 nm bis 5 nm. Eine besonders geringe Oberflächenrauheit kann erzielt werden, wenn die Keimschicht eine Dicke von 2,5 nm bis 3,5 nm aufweist.

Die Keimschicht weist Cu, Ti, Fe, Zn oder Cr auf. Keimschichten aus diesen Metallen sind vorteilhaft dazu geeignet, die beim Aufwachsen der Aluminiumschicht gewünschte Modifizierung der kristallinen Struktur zu bewirken, durch die die Rauheit der Aluminiumschicht vermindert wird.

Mit dem Verfahren wird vorteilhaft erreicht, dass die Aluminiumschicht eine rms (root mean square)-Oberflächenrauheit von weniger als 0,7 nm aufweist. Vorzugsweise beträgt die Oberflächenrauheit sogar weniger als 0,4 nm. Dies ist insbesondere bei einer Anwendung der Aluminiumschicht als Spiegelschicht vorteilhaft, da eine geringe Oberflächenrauheit eine hohe Reflexion bewirkt.

Bei einer bevorzugten Ausführungsform des Verfahrens wird eine Schutzschicht auf die Aluminiumschicht aufgebracht, wobei die Schutzschicht eine Dicke von nicht mehr als 5 nm aufweist. Es hat sich herausgestellt, dass aufgrund der mit dem Verfahren erzielten geringen Oberflächenrauheit der Aluminiumschicht bereits eine vergleichsweise dünne Schutzschicht mit einer Dicke von insbesondere nicht mehr als 5 nm ausreicht, die Aluminiumschicht ausreichend vor Umwelteinflüssen zu schützen. Die Schutzschicht ist bevorzugt eine Metallfluoridschicht, besonders bevorzugt eine MgF₂-Schicht.

Bei einer vorteilhaften Ausführungsform des Verfahrens wird das Substrat vor dem Aufbringen der Keimschicht mittels einer Plasmabehandlung gereinigt. Die Plasmabehandlung kann ein Ätzen des Substrats umfassen.

Es wird weiterhin ein mit dem Verfahren herstellbares optisches Element angegeben. Das optische Element umfasst ein Substrat, eine auf dem Substrat angeordnete metallische Keimschicht und eine über der Keimschicht angeordnete Aluminiumschicht. Die Aluminiumschicht ist insbesondere direkt auf der Keimschicht angeordnet. Die metallische Keimschicht ist eine nicht mehr als 5 nm dicke Schicht. Materialien für die Keimschicht sind Cu, Ti, Fe, Zn oder Cr.

Die Aluminiumschicht ist mindestens 30 nm dick und kann insbesondere als Spiegelschicht vorgesehen sein. Hierbei ist die Aluminiumschicht zwischen einschließlich 30 nm und einschließlich 100 nm dick. Die rms-Oberflächenrauheit der Spiegelschicht beträgt bevorzugt weniger als 0,7 nm, besonders bevorzugt weniger als 0,4 nm.

Das optische Element ist vorzugsweise ein Spiegel. Insbesondere kann das optische Element ein Spiegel für den UV-Bereich sein.

Die für das Verfahren beschriebenen vorteilhaften Ausgestaltungen gelten auch für das optische Element und umgekehrt.

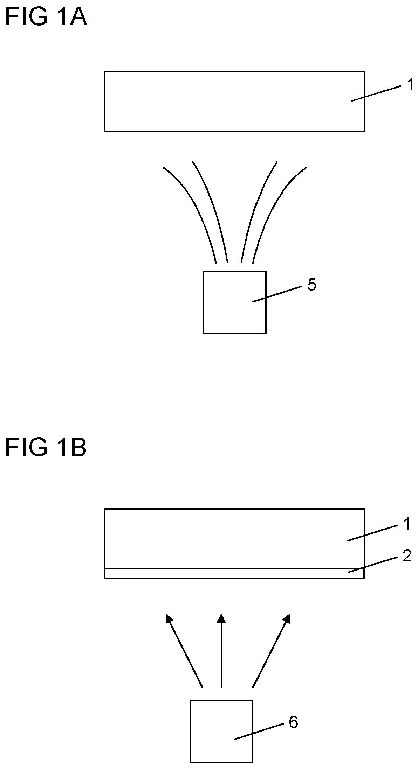

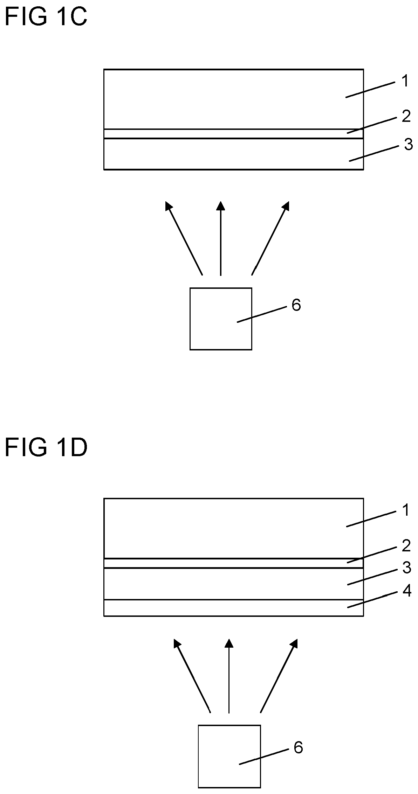

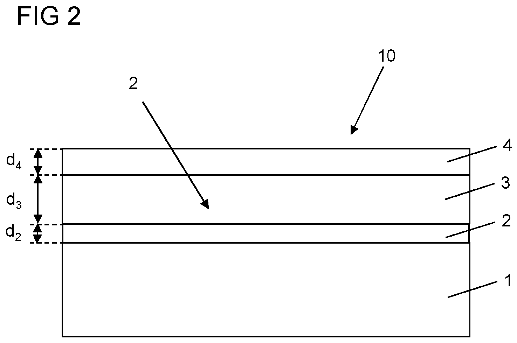

Die Erfindung wird im Folgenden anhand von Ausführungsbeispielen im Zusammenhang mit den Figuren 1 und 2 näher erläutert.

Es zeigen:
- Figuren 1A bis 1D: ein Beispiel des Verfahrens zur Herstellung einer Aluminiumschicht anhand von Zwischenschritten, und
- Figur 2: ein Beispiel eines optischen Elements mit der Aluminiumschicht.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

Bei dem in Figur 1A schematisch dargestellten optionalen Zwischenschritt des Verfahrens erfolgt eine Plasmavorbehandlung eines zu beschichtenden Substrats 1. Das Substrat 1 kann insbesondere der Grundkörper eines optischen Elements sein. Das Substrat 1 kann beispielsweise ein Glas, eine Glaskeramik, ein Halbleitermaterial oder ein Metall sein und kann eine ebene oder gekrümmte Oberfläche aufweisen. Das Substrat 1 wird beispielsweise in den Rezipienten einer Beschichtungsanlage eingeführt und durch Abpumpen ein Vakuum im Rezipienten hergestellt, insbesondere ein Vakuum mit einem Restgasdruck von weniger als 10⁻⁴ mbar. Die Plasmavorbehandlung und die nachfolgend beschriebenen weiteren Schritte erfolgen vorzugsweise bei einer Substrattemperatur T ≥ 60°C. Die Plasmavorbehandlung kann mit einer Plasmaquelle 5 erfolgen, mit der beispielsweise ArgonIonen in Richtung des Substrats 1 beschleunigt werden. Beispielsweise wird die Plasmaquelle 5 mit einer Bias-Spannung von 125 V betrieben, wobei die Bias-Spannung die Energie der auf das Substrat 1 auftreffen Ionen bestimmt. Die Dauer der Plasmabehandlung beträgt beispielsweise 300 Sekunden. Bei der Plasmavorbehandlung wird das Substrat 1 durch den Ionenbeschuss gereinigt und/oder an der Oberfläche geätzt.

Nach der optionalen Plasmavorbehandlung wird vorteilhaft ein Vakuum kleiner als 1 * 10⁻⁵ mbar im Rezipienten hergestellt. Nachfolgend wird, wie in Figur 1B schematisch dargestellt, eine Keimschicht 2 auf das Substrat 1 aufgebracht. Die Keimschicht 2 wird mit einem PVD (Physical Vapor Deposition)-Verfahren auf das Substrat aufgebracht, vorzugsweise durch Verdampfen aus einer Elektronenstrahl-Verdampfungsquelle 6. Bei der Keimschicht 2 handelt es sich um eine dünne Metallschicht, die eine Dicke von nicht mehr als 5 nm aufweist. Bevorzugt ist die Keimschicht 2 zwischen 2 nm und 5 nm und besonders bevorzugt zwischen 2,5 nm und 3,5 nm dick. Die Keimschicht 2 weist eines der Metalle Cu, Ti, Fe, Zn oder Cr auf.

In einem nachfolgenden Schritt, der in Figur 1C schematisch dargestellt ist, wird eine Aluminiumschicht 3 auf die Keimschicht 2 aufgebracht. Das Vakuum wird zwischen dem Aufbringen der Keimschicht 2 und dem Aufbringen der Aluminiumschicht 3 nicht unterbrochen, wobei der Restgasdruck vorzugsweise weniger als 1 * 10⁻⁵ mbar beträgt. Das Aufbringen der Aluminiumschicht 3 kann wiederum durch ein PVD-Verfahren, beispielsweise durch Verdampfen aus einer Elektronenstrahl-Verdampfungsquelle 6, erfolgen. Die Aluminiumschicht 3 wird mit einer Schichtdicke von mindestens 30 nm aufgebracht. Die Abscheiderate beim Aufbringen der Aluminiumschicht 3 beträgt vorzugsweise mindestens 20 nm/s.

Das Aufbringen der Keimschicht 2 vor dem Aufbringen der Aluminiumschicht 3 führt bei dem Verfahren dazu, dass die Aluminiumschicht eine besonders geringe Oberflächenrauheit aufweist.

Eine mit dem hierin beschriebenen Verfahren hergestellte Aluminiumschicht 3 wurde mit einem Rasterkraftmikroskop vermessen und weist eine rms-Oberflächenrauheit von nur 0,38 nm auf. Eine zum Vergleich ohne das vorherige Aufbringen einer Keimschicht hergestellte Aluminiumschicht weist dagegen eine rms-Oberflächenrauheit von 1,2 nm auf. Weiterhin wurde die Oberflächenrauheit der mit dem Verfahren hergestellten Aluminiumschicht 3 und der zum Vergleich hergestellten Aluminiumschicht nach einer Temperaturbehandlung bei T = 225 °C für t = 180 s mit einem Rasterkraftmikroskop untersucht. Nach der Temperaturbehandlung beträgt die Oberflächenrauheit bei der mit dem hierin beschriebenen Verfahren hergestellten Aluminiumschicht 0,36 nm und bei der zum Vergleich hergestellten Aluminiumschicht 1,86 nm. Es zeigt sich also, dass die mit dem Verfahren hergestellte Aluminiumschicht nicht nur nach der Herstellung, sondern auch nach einer Temperaturbehandlung eine wesentlich geringere Oberflächenrauheit aufweist als die zum Vergleich ohne Keimschicht hergestellte Aluminiumschicht.

Bei einem optionalen, in Figur 1D schematisch dargestellten Verfahrensschritt ist auf die Aluminiumschicht 3 eine Schutzschicht 4 aufgebracht worden. Die Schutzschicht 4 hat den Zweck, die Aluminiumschicht 3 vor Umwelteinflüssen zu schützen, insbesondere vor Feuchtigkeit. Die Schutzschicht 4 kann hierzu ein Metallfluorid, vorzugsweise MgF₂, aufweisen und ist vorzugsweise nicht mehr als 5 nm dick.

Ein auf diese Weise mit dem hierin beschriebenen Verfahren herstellbares optisches Element 10 ist in Figur 2 dargestellt. Das optische Element weist ein Substrat 1, eine auf dem Substrat angeordnete metallische Keimschicht 2 und eine auf der Keimschicht 2 angeordnete Aluminiumschicht 3 auf. Weiterhin kann auf der Aluminiumschicht 3 eine optionale Schutzschicht 4 angeordnet sein. Die Keimschicht 2 weist eine Dicke d₂ ≤ 5 nm auf. Vorzugsweise gilt 2 nm ≤ d₂ ≤ 5 nm, besonders bevorzugt 2,5 nm ≤ d₂ ≤ 3,5 nm. Das Material der Keimschicht ist vorzugsweise eines der Metalle Cu, Ti, Fe, Zn oder Cr. Die über der Keimschicht angeordnete Aluminiumschicht 3 weist eine Dicke d₃ von mindestens 30 nm auf, nämlich eine Dicke d₃ von 30 nm bis 100 nm. Die Aluminiumschicht 3 zeichnet sich insbesondere durch eine Oberflächenrauheit von nur weniger als 0,7 nm, bevorzugt von weniger als 0,4 nm, aus. Es hat sich herausgestellt, dass aufgrund der geringen Oberflächenrauheit der Aluminiumschicht 3 bereits eine vergleichsweise dünne Schutzschicht 4 ausreicht, die Aluminiumschicht 3 ausreichend vor Umwelteinflüssen zu schützen. Die Schutzschicht 4 weist vorzugsweise eine Dicke d₄ von nicht mehr als 5 nm auf.

Das optische Element 10 ist beispielsweise ein Spiegel, insbesondere ein Spiegel für den UV-Spektralbereich. Bei dem Spiegel kann es sich um einen ebenen oder gekrümmten Spiegel handeln.

Die Erfindung ist nicht durch die Beschreibung anhand der Ausführungsbeispiele beschränkt. Vielmehr umfasst die Erfindung jedes neue Merkmal sowie jede Kombination von Merkmalen in den Patentansprüchen , auch wenn dieses Merkmal oder diese Kombination selbst nicht explizit in den Ausführungsbeispielen angegeben ist.

## Patentansprüche

1. Verfahren zur Herstellung einer Aluminiumschicht (3), umfassend die Schritte:
- Aufbringen einer metallischen Keimschicht (2) auf ein Substrat (3), wobei die Keimschicht (2) Cu, Ti, Fe, Zn oder Cr aufweist und wobei die Keimschicht (2) eine Dicke von nicht mehr als 5 nm aufweist, und
- Aufbringen der Aluminiumschicht (3) auf die Keimschicht (2), wobei die Aluminiumschicht (3) zwischen einschließlich 30 nm und einschließlich 100 nm dick ist und wobei die Aluminiumschicht (3) eine rms-Oberflächenrauheit von weniger als 0,7 nm aufweist.

2. Verfahren nach Anspruch 1,
wobei die Keimschicht (2) zwischen 2 nm und 5 nm dick ist.

3. Verfahren nach einem der vorhergehenden Ansprüche,
wobei die Keimschicht (2) wischen 2,5 nm und 3,5 nm dick ist.

4. Verfahren nach einem der vorhergehenden Ansprüche,
wobei die Aluminiumschicht (3) eine rms-Oberflächenrauheit von weniger als 0,4 nm aufweist.

5. Verfahren nach einem der vorhergehenden Ansprüche,
wobei eine Schutzschicht (4) auf die Aluminiumschicht (3) aufgebracht wird, und wobei die Schutzschicht (4) eine Dicke von nicht mehr als 5 nm aufweist.

6. Optisches Element (10), umfassend
- ein Substrat (1),
- eine metallische Keimschicht (2) auf dem Substrat (1), wobei die Keimschicht (2) Cu, Ti, Fe, Zn oder Cr aufweist und wobei die Keimschicht (2) eine Dicke von nicht mehr als 5 nm aufweist, und
- eine auf der Keimschicht (2) angeordnete Aluminiumschicht (3), wobei die Aluminiumschicht (3) zwischen einschließlich 30 nm und einschließlich 100 nm dick ist und wobei die Aluminiumschicht (3) eine rms-Oberflächenrauheit von weniger als 0,7 nm aufweist.

7. Optisches Element nach Anspruch 6,
wobei die Aluminiumschicht (3) eine rms-Rauheit von weniger als 0,4 nm aufweist.

8. Optisches Element nach einem der Ansprüche 6 oder 7,
wobei das optische Element (10) ein Spiegel ist, und wobei die Aluminiumschicht (3) eine Spiegelschicht ist.

## Claims

1. A method for producing an aluminum layer (3), comprising the steps of
- depositing a metallic seed layer (2) on a substrate (3),
wherein the seed layer (2) comprises Cu, Ti, Fe, Zn or Cr and wherein the seed layer (2) has a thickness of not more than 5 nm, and
- applying the aluminum layer (3) to the seed layer (2),
wherein the aluminum layer (3) is between 30 nm inclusive and 100 nm inclusive thick and wherein the aluminum layer (3) has an rms surface roughness of less than 0.7 nm.

2. The method according to claim 1,
wherein the seed layer (2) is between 2 nm and 5 nm thick.

3. The method according to any one of the preceding claims, wherein the seed layer (2) is between 2.5 nm and 3.5 nm thick.

4. The method according to any one of the preceding claims, wherein the aluminum layer (3) has an rms surface roughness of less than 0.4 nm.

5. The method according to any one of the preceding claims, wherein a protective layer (4) is applied to the aluminum layer (3), and wherein the protective layer (4) has a thickness of not more than 5 nm.

6. An optical element (10) comprising
- a substrate (1),
- a metallic seed layer (2) on said substrate (1), wherein
the seed layer (2) comprises Cu, Ti, Fe, Zn or Cr and wherein the seed layer (2) has a thickness of not more than 5 nm, and
- an aluminum layer (3) disposed on the seed layer (2),
wherein the aluminum layer (3) is between 30 nm inclusive and 100 nm inclusive thick and wherein the aluminum layer (3) has an rms surface roughness of less than 0.7 nm.

7. The optical element according to claim 6,
wherein the aluminum layer (3) has an rms roughness of less than 0.4 nm.

8. The optical element according to any one of claims 6 or 7, wherein the optical element (10) is a mirror, and wherein the aluminum layer (3) is a mirror layer.

## Revendications

1. Procédé de fabrication d'une couche d'aluminium (3), comprenant les étapes suivantes :
- dépôt d'une couche d'amorçage métallique (2) sur un substrat (3), la couche d'amorçage (2) contenant du Cu, du Ti, du Fe, du Zn ou du Cr et présentant une épaisseur ne dépassant pas 5 nm, et
- dépôt de la couche d'aluminium (3) sur la couche d'amorçage (2), la couche d'aluminium (3) ayant une épaisseur comprise entre 30 nm inclus et 100 nm inclus, et la couche d'aluminium (3) présentant une rugosité de surface rms inférieure à 0,7 nm.

2. Procédé selon la revendication 1,
dans lequel la couche d'amorçage (2) a une épaisseur comprise entre 2 nm et 5 nm.

3. Procédé selon l'une des revendications précédentes,
dans lequel la couche d'amorçage (2) a une épaisseur comprise entre 2,5 nm et 3,5 nm.

4. Procédé selon l'une des revendications précédentes,
dans lequel la couche d'aluminium (3) présente une rugosité de surface rms inférieure à 0,4 nm.

5. Procédé selon l'une des revendications précédentes,
dans lequel une couche protectrice (4) est déposée sur la couche d'aluminium (3), et dans lequel la couche protectrice (4) présente une épaisseur ne dépassant pas 5 nm.

6. Élément optique (10) comprenant
- un substrat (1),
- une couche d'amorçage métallique (2) sur le substrat (1), la couche d'amorçage (2) contenant du Cu, du Ti, du Fe, du Zn ou du Cr et présentant une épaisseur ne dépassant pas 5 nm, et
- une couche d'aluminium (3) disposée sur la couche d'amorçage (2), la couche d'aluminium (3) ayant une épaisseur comprise entre 30 nm inclus et 100 nm inclus, et la couche d'aluminium (3) présentant une rugosité de surface rms inférieure à 0,7 nm.

7. Élément optique selon la revendication 6,
dans lequel la couche d'aluminium (3) présente une rugosité rms inférieure à 0,4 nm.

8. Élément optique selon l'une des revendications 6 ou 7,
dans lequel l'élément optique (10) est un miroir, et dans lequel la couche d'aluminium (3) est une couche miroir.
